# EUROPEAN PATENT SPECIFICATION

(11) **EP 4 325 584 B1**
(45) Date of publication and mention of the grant of the patent: **19.08.2026**
(21) Application number: 23786460.8
(22) Date of filing: 09.06.2023
(51) Int. Cl.: H10F 19/90, H10F 77/20

(54) **SOLAR CELL AND PHOTOVOLTAIC MODULE**
SOLARZELLE UND FOTOVOLTAISCHES MODUL
CELLULE SOLAIRE ET MODULE PHOTOVOLTAÏQUE

(30) Priority: 28.06.2022 CN 202210784277
(43) Date of publication of application: 21.02.2024
(73) Proprietor: Zhejiang Jinko Solar Co., Ltd., Haining, Zhejiang 314416 (CN); JINKO SOLAR CO., LTD, ShangRao, Jiangxi 334100 (CN)
(72) Inventor: HAO, Guohui, Jiaxing, Zhejiang 314416 (CN); HUANG, Shiliang, Jiaxing, Zhejiang 314416 (CN); ZHANG, Ningbo, Jiaxing, Zhejiang 314416 (CN); ZHANG, Hengshuo, Jiaxing, Zhejiang 314416 (CN)
(74) Representative: Balder IP Law, S.L.
(86) International application number: PCT/CN2023/099494
(87) International publication number: WO 2024/001727

(56) References cited:
- CN-A- 110 444 614
- CN-A- 112 234 109
- CN-A- 113 644 144
- CN-A- 115 172 484
- CN-U- 208 781 860
- CN-U- 212 783 469
- CN-U- 216 120 314
- US-A1- 2018 090 633
- US-A1- 2020 295 205

## Description

### TECHNICAL FIELD

The various embodiments described in this document relate in general to the field of photovoltaic power generation technology, and more specifically to a solar cell and a photovoltaic module.

### BACKGROUND

With the continuous development of photovoltaic power generation technology, the power generation efficiency of solar cells is increasingly improved. Especially, with the emergence of double-sided solar cells, both sides of the solar cell can be used for power generation. That is, not only can the light directly incident on the front of the solar cell be used for power generation, but also the light scattered and refracted on the back of the solar cell can be used for power generation, which can effectively improve the power generation efficiency of the solar cell.

In the solar cell, grid electrodes are formed by paste printing. Due to the high cost of printing paste, it is desired to reduce the unit consumption of printing paste for reducing the cost of the solar cell. However, solder pads on the grid electrodes in the solar cell generally have a relatively large area, which is not conducive to reducing the printing paste unit consumption of the solar cell.

CN212783469U relates to a double-sided solar cell and a cell module belong to the field of solar cells. The double-sided solar cell includes a cell base, a back electrode on a back surface thereof, and a front electrode on afront surface thereof. Wherein the bonding pads of the front electrode and the bonding pads of the back electrode are equal in number and are in one-to-one correspondence in position.

CN113644144A relates to an electrode pattern structure of a TOPCon solar cell. The electrode pattern structure comprises a front surface electrode and a back surface electrode, wherein the front surface electrode comprises a plurality of front surface main grids, a plurality of front surface fine grids and a plurality of front surface pad points, and can reduce the line width of the front surface main grids under the condition that the welding tension is not influenced so as to reduce the slurry loss of the front surface electrode and reduce the production cost, the back surface electrode comprises a plurality of back surface main grids and a plurality of back surface fine grids, the back surface main grids comprise a plurality of sectional silver electrode main grids and aluminum electrode main grids connected with the edges of the sectional silver electrode main grids in a wrapping manner, and the back surface fine grids comprise silver fine grids and aluminum fine grids which are stacked from inside to outside.

US2020295205A1 relates to a solar cell having an edge collecting electrode and a solar cell module comprising the same, the solar cell being capable of preventing a cell crack phenomenon caused by an interconnector and improving an adhesive characteristic of the interconnector by dividing a planar area of the solar cell into a main area and an edge area and positioning the outermost contact point of the interconnector at a boundary between the main area and the edge area, and being capable of improving carrier collecting efficiency by arranging, in the edge area, the edge collecting electrode and the branched electrode connection collection electrode which are physically separated from the interconnector.

US20180090633A1 relates to a solar cell including a semiconductor substrate, a conductive region on or at the semiconductor substrate, and an electrode electrically connected to the conductive region. The electrode includes a plurality of finger lines formed in a first direction and parallel to each other and a bus bar electrically connected to the plurality of finger lines and formed in a second direction crossing the first direction. The bus bar includes a plurality of pad portions positioned in the second direction, and the bus bar has a plurality of regions, which are different from each other in at least one of an arrangement and an area of the plurality of pad portions, in the second direction.

### SUMMARY

The present invention aims to provide a solar cell and a photovoltaic module. The invention is set out in the appended set of claims.

Embodiments of the disclosure provide a solar cell. The solar cell includes a substrate having a front side and a back side, a plurality of front electrodes disposed on the front side, and a plurality of back electrodes disposed on the back side. The plurality of front electrodes include a plurality of front main busbars and a plurality of front finger electrodes, each respective front finger electrode of the plurality of front finger electrodes is electrically connected with the plurality of front main busbars, the number of the plurality of front main busbars is 6 to 20, and the number of the plurality of front finger electrodes is 45 to 75. The plurality of back electrodes include a plurality of back main busbars and a plurality of back finger electrodes, each respective back finger electrode of the plurality of back finger electrodes is electrically connected with the plurality of back main busbars, the number of the plurality of the back main busbars is 6 to 20, and the number of the plurality of back finger electrodes is 50 to 80. For each respective front main busbar of at least one front main busbar of the plurality of front main busbars, the respective front main busbar has 4 to 10 first solder pads. For each respective back main busbar of at least one back main busbar of the plurality of back main busbars, the respective back main busbar has 4 to 10 second solder pads. Each respective first solder pad has an area smaller than an area of a corresponding second solder pad.

Embodiments of the disclosure further provide a photovoltaic module. The photovoltaic module includes at least one cell string, a plurality of encapsulation films, and a plurality of cover plates. Each cell string is formed by connecting a plurality of solar cells, and each of the solar cells is the solar cell of the present invention.

In some embodiments, a plurality of first solder pads of the respective front main busbar include two third solder pads located at the ends of the respective front main busbar and a plurality of fourth solder pads located between the two third solder pads, and where each respective third solder pad of the two third solder pads has an area larger than an area of a corresponding fourth solder pad of the plurality of fourth solder pads; and a plurality of second solder pads of the respective back main busbar include two fifth solder pads located at the ends of the respective back main busbar and a plurality of sixth solder pads located between the two fifth solder pads, and where each respective fifth solder pad of the two fifth solder pads has an area larger than an area of a corresponding sixth solder pad of the plurality of sixth solder pads.

In some embodiments, the area of the respective third solder pad is less than or equal to 2/3 of the area of the respective fifth solder pad.

In some embodiments, the respective third solder pad and the respective fifth solder pad are both rectangular solder pads. A ratio of a length of the respective third solder pad to a length of the respective fifth solder pad and a ratio of a width of the respective third solder pad to a width of the respective fifth solder pad are both greater than 2/3 and less than 1.

In some embodiments, each respective fourth solder pad has an area less than or equal to 2/3 of an area of a respective sixth solder pad.

In some embodiments, the respective third solder pad and the corresponding fourth solder pad are rectangular solder pads, the respective third solder pad has a length in a range of 0.5mm to 0.7mm and has a width in a range of 0.9mm to 1.1mm, and the corresponding fourth solder pad has a length in a range of 0.3mm to 0.5mm and has a width in a range of 0.7mm to 0.9mm.

In some embodiments, the respective fifth solder pad and the corresponding sixth solder pad are rectangular solder pads, the respective fifth solder pad has a length in a range of 0.7mm to 0.9mm and has a width in a range of 1.1mm to 1.3mm, and the corresponding sixth solder pad has a length in a range of 0.5mm to 0.7mm and has a width in a range of 0.7mm to 0.9mm.

In the present invention, a length of the respective first solder pad in a first direction is less than or equal to 2/3 of a length of the corresponding second solder pad in the first direction, and where the first direction is parallel to an extension direction of the respective front main busbar.

In some embodiments, the length of the respective first solder pad in the first direction is greater than a width of the respective front main busbar, and the length of the corresponding second solder pad in the first direction is greater than a width of the respective back main busbar.

In some embodiments, a spacing between each two adjacent first solder pads and a spacing between each two adjacent second solder pads are both in a range of 15mm to 20mm.

### BRIEF DESCRIPTION OF THE DRAWINGS

One or more embodiments are illustrated by the figures in the corresponding drawings, which are not to be limiting to the embodiments, and the figures in the drawings are not to be limiting to scale unless specifically stated.
FIG. 1 is a schematic structural view of a solar cell according to embodiments of the disclosure.
FIG. 2 is a schematic structural view of front electrodes in a solar cell according to embodiments of the disclosure.
FIG. 3 is an enlarged schematic structural view of part A in FIG. 2.
FIG. 4 is a schematic structural view of back electrodes in a solar cell according to embodiments of the disclosure.
FIG. 5 is an enlarged schematic structural view of part B in FIG. 4.
FIG. 6 is a schematic structural view of main bus bars of front electrodes during step-by-step printing of a solar cell according to embodiments of the disclosure.
FIG. 7 is a schematic structural view of finger electrodes of front electrodes during step-by-step printing of a solar cell according to embodiments of the disclosure.
FIG. 8 is a schematic structural view of main bus bars of back electrodes during step-by-step printing of a solar cell according to embodiments of the disclosure.
FIG. 9 is a schematic structural view of finger electrodes of back electrodes during step-by-step printing of a solar cell according to embodiments of the disclosure.
FIG. 10 is a cross-sectional structural view of a photovoltaic module according to embodiments of the disclosure.
FIG. 11 is a cross-sectional structural view of a photovoltaic module according to other embodiments of the disclosure.

### DETAILED DESCRIPTION OF THE EMBODIMENTS

In a solar cell and a photovoltaic module provided in the present invention, by making an area of each of a plurality of first solder joints (solder pads) on each respective front main grid line (main busbar) of at least one front main busbar of a plurality of front main busbars smaller than an area of a corresponding second solder pad of a plurality of second solder pads on a corresponding back main busbar, unit consumption of printing paste during preparation of the solar cell can be reduced. In this way, it is possible to avoid that a welding tension between a respective back solder pad (solder pad on the back side of the substrate) and a corresponding solder strip is significantly less than a welding tension between a respective front solder pad (the solder pad on the front side of the substrate) and the corresponding solder strip when an area of the respective front solder pad and an area of the respective back solder pad are the same. Moreover, after the area of each first solder pad on the respective front main busbar is reduced, the welding tension between the respective first solder pad and the corresponding solder strip can still meet the requirements. Therefore, the unit consumption of the printing paste of the solar cell can be reduced by reducing the area of each first solder pad on corresponding front main busbars under the condition that the welding tension between each respective front/back solder pad on the substrate and the corresponding solder strip meets the requirements.

In some embodiments, the plurality of first solder pads of the respective front main busbar include two third solder pads located at ends of the respective front main busbar and a plurality of fourth solder pads located between the two third solder pads, where an area of each of the two third solder pads is larger than an area of a corresponding fourth solder pad of the plurality of fourth solder pads. The plurality of second solder pads of the respective back main busbar include two fifth solder pads located at ends of the respective back main busbar, and a plurality of sixth solder pads located between the two fifth solder pads, where an area of each of the fifth solder pads is larger than an area of a corresponding sixth solder pad of the plurality of sixth solder pads. In this way, by making the area of each of the solder pads at the ends of the respective main busbar larger than the area of any of the solder pads at a middle position of the respective main busbar, it is possible to effectively avoid poor welding or welding offset at the ends of the respective main busbar.

In some embodiments, an area of each respective third solder pad is less than or equal to 2/3 of an area of a corresponding fifth solder pad. By making the area of each third solder pad less than or equal to 2/3 of the area of the corresponding fifth solder pad, it is possible to ensure a welding tensile force between the respective third solder pad and the solder strip to be close to the welding tensile force between the corresponding fifth solder pad and the solder strip, so that the unit consumption of printing paste of the solar cell can be reduced to the greatest extent on the premise that the welding tension between each respective front/back solder pad and the corresponding solder strip meets the requirements.

In some embodiments, the respective third solder pad and the corresponding fifth solder pad are both rectangular solder pads. A ratio of a length of the respective third solder pad to a length of the corresponding fifth solder pad and a ratio of a width of the respective third solder pad to a width of the corresponding fifth solder pad are both greater than 2/3 and less than 1. Therefore, the area of the respective third solder pad can be kept within a range of less than or equal to 2/3 of the area of the corresponding fifth solder pad by reducing both the length and the width of the respective third solder pad.

In some embodiments, an area of each respective fourth solder pad is less than or equal to 2/3 of an area of a corresponding sixth solder pad. In this way, by making the area of the respective fourth solder pad less than or equal to 2/3 of the area of the corresponding sixth solder pad, it is possible to ensure the welding tensile force between the respective fourth solder pad and the solder strip to be close to the welding tensile force between the corresponding sixth solder pad and the solder strip, so that the unit consumption of printing paste of the solar cell can be reduced to the greatest extent on the premise that the welding tension between each respective front/back solder pad and the solder strip meets the requirements.

In the present invention, a length of each respective first solder pad in a first direction is less than or equal to 2/3 of a length of a respective second solder pad in the first direction, where the first direction is parallel to an extension direction of the respective front main busbar. In this way, by reducing the size of each first solder pad in the first direction, the welding tension between the first solder pad and the solder strip can be significantly reduced.

In some embodiments, the length of the respective first solder pad in the first direction is greater than a width of the respective front main busbar, and the length of each respective second solder pad in the first direction is greater than a width of a respective back main busbar. In this way, by making the length of the respective solder pad in the first direction larger than the width of the respective main busbar, the respective solder pad can be protruded from both sides of the respective main busbar in the extension direction of respective the main busbar, thereby facilitating positioning of the solder strip during welding.

In some embodiments, a spacing between each two adjacent first solder pads and a spacing between each two adjacent second solder pads are both in a range of 15mm to 20mm. In this way, it is possible to avoid affecting the welding process due to a relatively small spacing between the adjacent solder pads, and avoid affecting a connection effect of the solder strip on solar cells due to a relatively large spacing between the adjacent solder pads.

The embodiments of the disclosure will be described in detail below with reference to the accompanying drawings. However, those of ordinary skill in the art can understand that, in various embodiments of the disclosure, many technical details are set forth in order to provide the reader with a better understanding of the disclosure. However, the technical solutions claimed in the disclosure may be realized even without these technical details and various changes and modifications based on the following embodiments.

In order to clarify the objects, technical solutions, and advantages of the embodiments of the disclosure, the following will provide a detailed explanation of each embodiment of the disclosure in conjunction with the accompanying drawings. However, ordinary technical personnel in this field can understand that many technical details have been proposed in various embodiments of the present application in order to provide readers with a good understanding of the disclosure. However, even without these technical details and various changes and modifications based on the following embodiments, the technical solution required for protection in the disclosure can still be achieved. The division of the following embodiments is for convenience in description and should not constitute any limitations on the specific embodiments of the disclosure. All embodiments can be combined and referenced with each other without contradiction.

For solar cells with double-sided power generation, grid lines (i.e., electrodes) are arranged on both a front side and a back side of a substrate of the soler cell. The electrodes on both the front side and back side of the substrate of the solar cell include main busbars and secondary grid lines (finger electrodes) that are intersected with one another (generally perpendicular to one another). The main busbars and the finger electrodes are generally formed by sintering after a required pattern is obtained through printing with metal paste (generally silver paste). The finger electrodes are used to direct the current, and the main busbars are used to converge currents from the finger electrodes. In order to improve the power generation efficiency of the solar cell and reduce the cost, a multi-busbar (MBB) technology is generally adopted. That is, both the front side and the back side of the substrate are printed with multiple main busbars. The number of the main busbars is generally greater than or equal to 9. For example, the solar cell is a solar cell including 9 main busbars, 12 main busbars, 13 main busbars, 15 main busbars, 16 main busbars, 18 main busbars, or 20 main busbars on each of the front side and the back side of the substrate. In the MBB technology, the number of the finger electrodes is reduced by increasing the number of the main busbars, so that a spacing between adjacent finger electrodes is increased and the cost of the solar cell is reduced. In addition, a shading area and unit consumption of the silver paste are reduced by reducing a line width of each finger electrode. Moreover, by means of the solder pads on the respective main busbar, the reliability of welding accuracy and welding tension between the solar cells and solder strips is ensured.

In the solar cells adopted with the MBB technology, the main busbars on both the front side and the back side of the substrate are basically the same. In order to ensure that the welding tension between the solar cells and the solder strips during welding can meet the requirements and considering the welding offset comprehensively, the area of each solder pad on the respective main busbar is designed to be relatively large.

In some cases, since the area of each solder pad on both the front side and the back side of the substrate of the solar cell is relatively large, the requirements of welding tension can be met, and the scheme of keeping the area of each solder pad on the front side to be consistent with the area of the corresponding solder pad on the back side is generally adopted. However, it is found through experiments that when the area of each solder pad on the front side of the substrate is consistent with the area of the corresponding solder pad on the back side of the substrate, the welding tension between each solder pad on the back side of the substrate and the solder strip is only about 70% of the welding tension between the corresponding solder pad on the front side of the substrate and the solder strip. That is, when the area of each solder pad on the front side is consistent with the area of the corresponding solder pad on the back side, the welding tension between the respective solder pad on the front side of the substrate and the solder strip is significantly different from that between the corresponding solder pad on the back side and the solder strip. The reason for this obvious difference lies in difference of welding processes carried out on the front side and back side of the substrate and lies in difference of electrode pastes printed on the front side and back side of the substrate. In actual situations, after the solar cell is transferred to a welding position, the welding of the welding strips on the front side and back side of the substrate is completed after being heated by infrared lamps. However, in order to avoid heat loss, a welding bottom plate on the back of the substrate is maintained at a heat preservation temperature. In addition, the untimely heat dissipation on the back of the substrate may lead to the untimely cooling of the solder strip on the back of the substrate during the welding, which may eventually lead to the low welding tension of the solder strip on the back side of the substrate of the solar cell. Moreover, in the actual situation, types of printing paste on both the front side and the back side of the substrate are different, and composition of printing paste of different types may also be different, which may also lead to that welding tension of the solder strip at each solder pad on the front side and welding tension of the solder strip at a corresponding solder pad on the back side of the substrate different.

It is to be noted that corresponding solder pads refer to a position corresponding relationship between each respective solder pad on a respective main busbar on the front side of the substrate and a corresponding solder pad on a respective main busbar on the back side of the substrate in a direction perpendicular to the substrate. In the actual situation, the solder pads on the main busbars on both the front side and the back side of the substrate can keep strict position correspondence in the direction perpendicular to the surface of the substrate (a projection of the respective solder pad on the front side and a projection of the corresponding solder pad on the back side in the direction perpendicular to the substrate are at least partially overlapped), or can also be staggered by a distance. In the case of staggered arrangement of the solder pads on both the front side and the back side of the substrate, it can avoid cracking and fragment of the solar cell caused by overlapping welding stress concentration regions on the substrate. In addition, the number of solder pads on the respective main busbar on the front side (i.e., front main busbar) of the substrate and the number of solder pads on the respective main busbar on back side (back main busbar) of the substrate can also keep strict correspondence or differ by a certain range.

According to the test results, it can be concluded that the unit consumption of printing paste for the solar cell can be reduced by reducing the area of each of at least one solder pad of the plurality of solder pads on the front side of the substrate when both the welding tension between the respective solder pad on the front side of the substrate and the solder strip and the welding tension between the corresponding solder pad on the back side of the substrate and the solder strip meet the requirements. In addition, when the welding tension between the respective solder pad on the front side of the substrate and the solder strip is kept the same as the welding tension between the respective solder pad on the back side of the substrate and the solder strip, the area of each of the at least one solder pad on the front side can be reduced by more than one third relative to the area of a corresponding solder pad on the back side. In this way, after the area of each of the at least one solder pad on the front side is reduced, not only can the unit consumption of printing paste of the solar cell be reduced, but also the welding tension between each of the at least one solder pad on the front side and the solder strip may not be affected to meet the reliability requirements. In other words, the welding tension between each of the at least one solder pad on the front side and the solder strip can still meet the requirements.

Embodiments of the disclosure provide a solar cell. The solar cell includes a substrate 10, a plurality of front electrodes 20 disposed on a front side of the substrate 10, and a plurality of back electrodes 30 disposed on a back side of the substrate 10. The plurality of front electrodes 20 include a plurality of front main busbars 21 and a plurality of front finger electrodes 22, and each of the plurality of front finger electrodes 22 is electrically connected with the plurality of front main busbars 21. There are 6 to 20 front main busbars 21 and there are 45 to 75 front finger electrodes 22. The plurality of back electrodes 30 include a plurality of back main busbars 31 and a plurality of back finger electrodes 32, and each of the plurality of back finger electrodes 32 is electrically connected with the plurality of back main busbars 31. There are 6 to 20 back main busbars 31 and there are 50 to 80 back finger electrodes 32. For each respective front main busbar 21 of at least one front main busbar 21 of the plurality of front main busbars 21, the respective front main busbar 21 has 4 to 10 first solder pads 211 that are arranged at intervals in a first direction, where the first direction is parallel to an extension direction of the respective front main busbar. For each respective back main busbar 31 of at least one back main busbar 31 of the plurality of back main busbars 31, the respective back main busbar 31 has 4 to 10 second solder pads 311 that are arranged at intervals in the first direction. Each first solder pad 211 has an area smaller than an area of a corresponding second solder pad 311.

There may be 35 to 100 front finger electrodes 22 and there may be 38 to 120 back finger electrodes 32. For example, the number of the plurality of front finger electrodes 22 is in a range of 35 to 46, 46 to 58, 58 to 69, 69 to 81, 81 to 90, or 90 to 100. The number of the plurality of back finger electrodes 32 is in a range of 38 to 49, 49 to 64, 64 to 73, 73 to 89, 89 to 108, or 108 to 120. The number of the front finger electrodes 22 may be 35, 41, 45, 50, 55, 60, 65, 70, 75, 83, 91, or 99. The number of the back finger electrodes 32 may be 39, 44, 48, 50, 55, 60, 65, 70, 75, 83, 91, 99, 112, or 120, or the like.

The substrate 10 is a base for forming electrodes of the solar cell, and the substrate 10 is generally a silicon substrate. Both the front side and the back side of the substrate 10 may be printed with metal paste to form electrodes with specific patterns. The electrodes printed on the front side of the substrate 10 are the front electrodes 20, and the grid electrodes printed on the back side of the substrate 10 are the back electrodes 30. In general, the front side of the substrate 10 is a light-receiving surface for receiving solar energy generated by directly incident light rays. The back side of the substrate 10 is a backlight surface for receiving solar energy generated by scattered or refracted light rays. In actual situations, both the number of the front main busbars 21 and the back main busbars 31 may be 9, 12, 13, 15, 16, 18, or 20. The number of the front finger electrodes 22 may be 45, 50, 55, 60, 65, 70, or 75. The number of the back finger electrodes 32 may be 50, 55, 60, 65, 70, 75, or 80. In addition, the solar cell provided in embodiments of the disclosure may be a whole cell or a half-cut cell, and the half-cut cell is formed by dividing the whole cell into two halves in a direction perpendicular to an extension direction of the respective main busbar.

Each of the front finger electrodes 22 has a width in a range of 10µm to 80µm in an extension direction of a respective front main busbar. For example, the width of the respective front finger electrode 22 is in a range of 10µm to 22µm, 22µm to 34µm, 34µm to 46µm, 46µm to 58µm, 58µm to 70µm, 70µm to 80µm, or 20µm to 60µm. The width of the respective front finger electrode 22 may be 13µm, 19µm, 26µm, 35µm, 47µm, 61µm, or 73µm.

Each of the front finger electrodes 22 has a height in a range of 6µm to 18µm in a direction perpendicular to the substrate. The height of the respective front finger electrode 22 may be 6µm to 9.3µm, 9.3µm to 12.4µm, 12.4µm to 15.1µm, or 15.1µm to 18µm. The height of the respective front finger electrode 22 may be 6.1µm, 7.3µm, 8.2µm, 9.5µm, 10.4µm, 11.1µm, 12.6µm, 14.6µm, 16.3µm, 17.6µm, or 18µm.

Each of the back finger electrodes 32 has a width in a range of 10µm to 80µm in an extension direction of a respective back main busbar. The respective back finger electrode 32 may have the width of 10µm to 23µm, 23µm to 33µm, 33µm to 45µm, 45µm to 54µm, 54µm to 68µm, 68µm to 80µm, or 20µm to 60µm. The respective back finger electrode 32 may have the width of 12µm, 21µm, 28µm, 38µm, 52µm, 63µm, or 78µm.

Each of the back finger electrodes 32 has a height in a range of 6µm to 18µm in a direction perpendicular to the surface of the substrate. The height of the respective back finger electrode 32 may be 6µm to 9.1µm, 9.1µm to 12.3µm, 12.3µm to 15.6µm, or 15.6µm to 18µm. The height of the respective back finger electrode 32 may be 6.2µm, 7.1µm, 8.3µm, 9.4µm, 10.1µm, 11.3µm, 12.7µm, 14.8µm, 16.4µm, 17.1µm, or 18µm.

Each of the front main busbars 21 has a width in a range of 15µm to 100µm in an extension direction of a respective front finger electrode. The width of the respective front main busbar 21 may be 15µm to 24µm, 24µm to 42µm, 42µm to 53µm, 53µm to 65µm, 65µm to 82µm, 82µm to 100µm, or 18µm to 80µm. The width of the respective front main busbar 21 may be 18µm, 26µm, 38µm, 51µm, 69µm, 81µm, or 98µm.

Each of the front main busbars 21 has a height in a range of 3µm to 12µm in a direction perpendicular to the surface of the substrate. The height of the respective front main busbar 21 may be 3µm to 5.3µm, 5.3µm to 8.4µm, 8.4µm to 10.1µm, or 10.1µm to 12µm. The height of the respective front main busbar 21 may be 3.1µm, 4.3µm, 5.2µm, 6.5µm, 7.4µm, 8.1µm, 9.6µm, 10.6µm, 11.3µm, 11.6µm, or 12µm.

Each of the back main busbars 31 has a width in a range of 15µm to 100µm in an extension direction of a back front finger electrode. The respective back main busbar 31 may have the width in the range of 15µm to 26µm, 26µm to 43µm, 43µm to 54m, 54µm to 66µm, 66µm to 84µm, 84µm to 100µm, or 18µm to 80µm. The width of the respective back main busbar 31 may be 18µm, 26µm, 38µm, 51µm, 69µm, 81µm, or 98µm.

Each of the back main busbars 31 has a height in a range of 3µm to 12µm in a direction perpendicular to the surface of the substrate. The height of the respective back main busbar 31 may be in a range of 3µm to 4.1µm, 4.1µm to 6.3µm, 6.3µm to 8.6µm, or 8.6µm to 12µm. The height of the respective back main busbar 31 may be 3.2µm, 4.1µm, 5.3µm, 6.4µm, 7.1µm, 8.3µm, 9.7µm, 10.8µm, 11.4µm, or 12µm.

It is to be noted that in the solar cell, not too many solder pads could be arranged. The too many solder pads may cause high unit consumption of printing paste and large shading area. In addition, during encapsulating of the photovoltaic module, if too many solder pads are arranged, the soldering process may be affected. When the respective electrode includes 4 to 10 solder pads, the unit consumption of printing paste can be reduced and the shading area can be reduced. In the actual situation, the respective front main busbar 21 may include 4, 5, 7, 9, or 10 first solder pads 211, and the respective back main busbar 31 may include 4, 5, 7, 9, or 10 second solder pads 311.

In addition, a corresponding relationship between the respective first solder pad 211 and the corresponding second solder pad 311 means that a projection of the respective first solder pad 211 and a projection of the corresponding second solder pad 311 in the direction perpendicular to the substrate 10 are at least partially overlapped, or the respective first solder pad 211 and the corresponding second solder pad 311 are in a same region according to a position division of the electrodes, e.g., both the respective first solder pad 211 and the corresponding second solder pad 311 are in a region where the head and tail solder joints are located or a region where middle solder joints are located. The head and tail solder pads include solder pads, and each of which is spaced apart by a distance within 10% of a length of the solar cell from an end of the respective main busbar. Each of other solder pads spaced apart by a distance greater than 10% of the length of the solar cell from the end of the respective main busbar are middle solder pads.

In the soler cell provided in the present invention, by making the area of the respective first solder pad 211 on each of the at least one front main busbar 21 smaller than the area of the respective second solder pad 311 on the corresponding back main busbar 31, the printing paste unit consumption during the preparation of the solar cell can be reduced. Therefore, it is possible to avoid that the welding tension between the respective back solder pad and the solder strip is significantly less than that between the respective front solder pad and the solder strip when the area of the respective front solder pad and the area of the respective back solder pad are the same. Furthermore, after the area of the respective first solder pad 211 on each of the at least one front main busbar 21 is reduced, the welding tension between the respective first solder pad 211 and the solder strip can still meet the requirements. Thus, on condition that the welding tension between the respective front solder pad on the substrate 10 and the solder strip and the welding tension between the respective back solder pad on the substrate 10 and the solder strip meet the requirements, by reducing the area of the respective first solder pad 211 on each of the at least one front main busbar 21, the unit consumption of the printing paste of the solar cell can be reduced.

In some embodiments of the present disclosure, the plurality of first solder pads 211 of the respective front main busbar 21 may include two third solder pads 2111 each located at a corresponding end of the respective front main busbar 21, and a plurality of fourth solder pads 2112 located between the two third solder pads 2111. An area of each respective third solder pad 2111 is larger than an area of a respective fourth solder pad 2112. The plurality of second solder pads 311 of the respective back main busbar 31 may include two fifth solder pads 3111 each located at a corresponding end of the respective back main busbar 31, and a plurality of sixth solder pads 3112 located between the two fifth solder pads 3111. An area of each respective fifth solder pad 3111 is larger than an area of a respective sixth solder pad 3112.

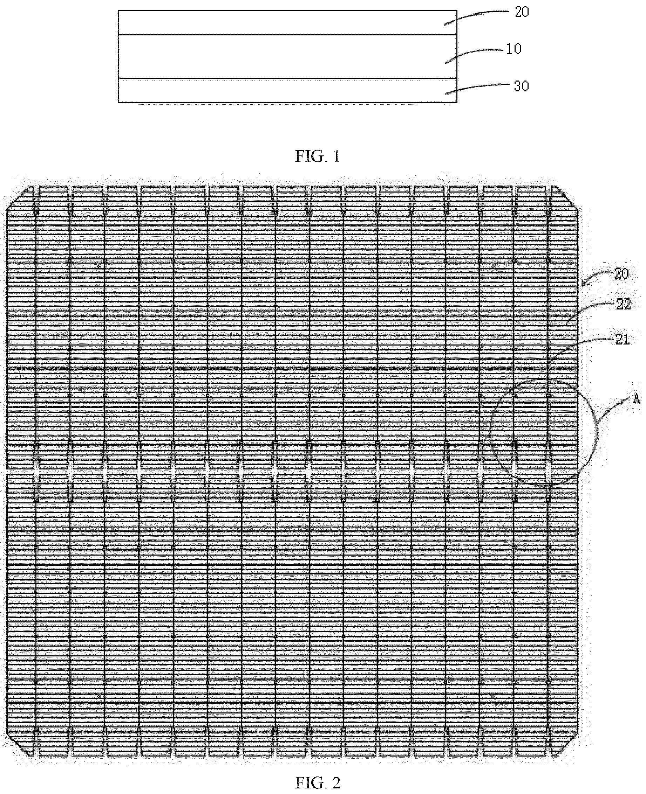

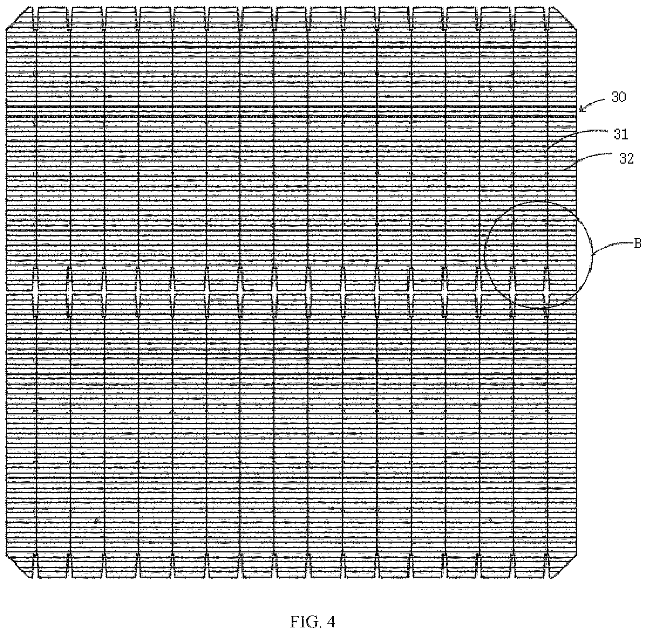

As shown in FIGS. 1 to 5, the third solder pads 2111 and the fifth solder pads 3111 are located at the ends of the corresponding main busbars, and the fourth solder pads 2112 and the sixth solder pads 3112 are middle solder pads located between the two ends of the corresponding main busbars. The area of the respective third solder pad 2111 is larger than the area of the respective fourth solder pad 2112, and the area of the respective fifth solder pad 3111 is larger than the area of the respective sixth solder pad 3112. In other words, for a same main busbar, the area of each of the two solder pads located at both ends of the main busbar is larger than the area of any of other solder pads (i.e., the solder pads located in the middle region of the main busbar) between the two solder pads of the main busbar.

By making the area of each of the solder pads located at the ends of the respective front main busbar 21 and the respective back main busbar 31 larger than the area of any of the other solder pads located in the middle region, it is possible to effectively avoid poor welding or welding offset at the ends of the respective front main busbar 21 and the respective back main busbar 31, and to ensure the welding effect between the ends of the respective front main busbar 21 and the respective back main busbar 31 and the solder strip.

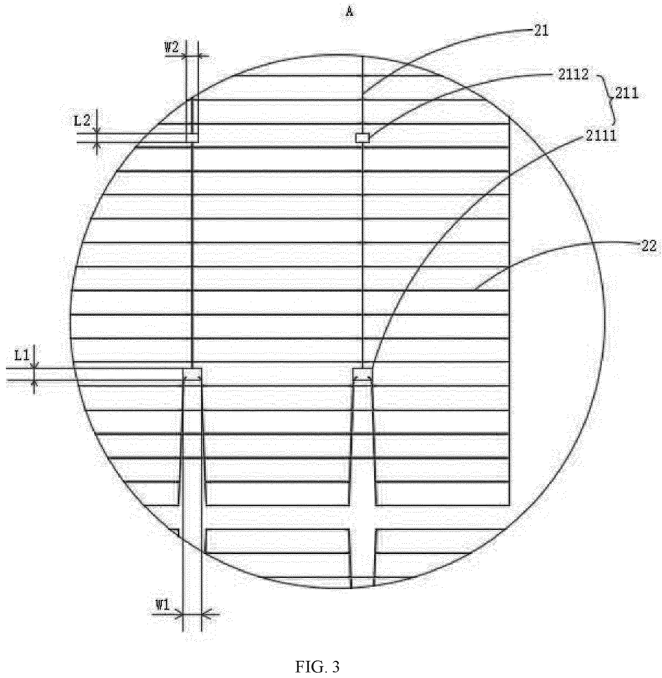

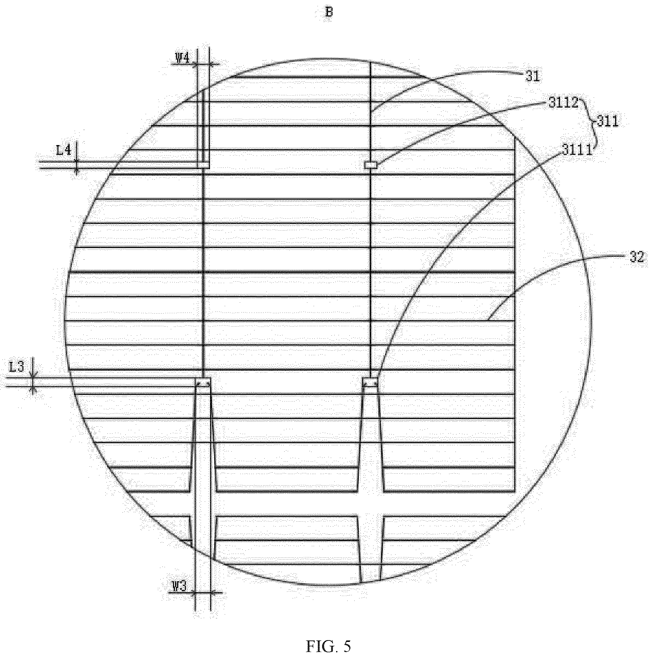

Referring further to FIG. 3 and FIG. 5, the respective front main busbar 21 splits at one or both ends of the respective front main busbar to form branch busbar electrodes at the one or both ends of the respective front main busbar 21 and the respective back main busbar 31 splits at one or both ends of the respective back main busbar to form branch busbar electrodes at one or both ends of the respective back main busbar 31. By designing each end of the respective front main busbar 21 and each end of the respective back main busbar 31 in a bifurcated structure, each of the front finger electrodes 22 and the back finger electrodes 32 which are disconnected and near the ends of the cell can avoid the corresponding solder strip, thereby reducing the risk of cracking and virtual welding at the ends of the electrodes during encapsulation of the photovoltaic module.

In addition, according to the test results, the area of the respective front solder pad can be reduced by more than one-third with respect to the area of the respective back solder pad on condition that the welding tension at each respective front solder pad on the substrate 10 and the corresponding solder strip and the welding tension at a respective back solder pad on the substrate 10 and the corresponding solder strip are kept the same. In a case where each solder pad is in a shape of a rectangle, an area of each of the head and tail solder pads on the respective back main busbar 31 of the substrate 10 may be in a range of 0.70 square millimeters to 1.20 square millimeters, and an area of each of the head and tail solder pads on the respective front main busbar 21 of the substrate 10 may be in a range of 0.40 square millimeters to 0.70 square millimeters. An area of each of the middle solder pads on the respective back main busbar 31 of the substrate 10 may be in a range of 0.35 square millimeters to 0.70 square millimeters, and the area of each of the middle solder pads on the respective front main busbar 21 of the substrate 10 may be in a range of 0.20 square millimeters to 0.45 square millimeters.

Therefore, in some embodiments of the disclosure, the area of the respective third solder pad 2111 may be less than or equal to 2/3 of the area of the respective fifth solder pad 3111.

That is, the area of each of the head and tail solder pads located at the ends of the respective front main busbar 21 is less than or equal to 2/3 of the area of any of the head and tail solder pads located at the ends of the respective back main busbar 31. By reducing the area of the respective third solder pad 2111 to be less than or equal to 2/3 of the area of the respective fifth solder pad 3111, the welding tension at each respective front solder pad on the substrate 10 and the corresponding solder strip and the welding tension at the respective back solder pad on the substrate 10 and the corresponding solder strip are kept within a close range. Therefore, it is possible to reduce the printing paste consumption of the solar cell to a maximum extent on the premise that the welding tension between the respective front solder pad of the substrate 10 and the corresponding solder strip and the welding tension between the respective back solder pad of the substrate 10 and the corresponding solder strip meet the requirements.

As shown in FIGS. 3 and 5, each of the third solder pad 2111 and the fifth solder pad 3111 may be a rectangular solder pad. A ratio of a length of the respective third solder pad 2111 to a length of the respective fifth solder pad 3111 and a ratio of a width of the respective third solder pad 2111 to a width of the respective fifth solder pad 3111 are both greater than 2/3 and less than 1.

Each solder pad is generally a rectangular solder pad. The length of the respective solder pad refers to a size of the respective solder pad in an extension direction of the respective main busbar, and a width of the respective solder pad refers to a size of the respective solder pad in an extension direction of a respective finger electrode. In addition, the width of the respective solder pad may be larger than the length of the respective solder pad, which is to ensure the accuracy of alignment between the respective solder pad and the solder strip.

By making the ratio of the length of the respective third solder pad 2111 to the length of the respective fifth solder pad 3111 and the ratio of the width of the respective third solder pad 2111 to the width of the respective fifth solder pad 3111 both greater than 2/3 and less than 1, the area of the respective third solder pad 2111 can be reduced to be less than or equal to 2/3 of the area of the respective fifth solder pad 3111.

In other embodiments, the respective solder pad may also be a diamond-shaped or triangular solder pad. The front solder pads may be identical with or different from the back solder pads in shape.

In addition, an area of each respective fourth solder pad 2112 may be less than or equal to 2/3 of an area of a respective sixth solder pad 3112.

That is, the area of each respective middle solder pad located at the middle region of the respective front main busbar 21 is less than or equal to 2/3 of the area of any of the middle solder pads located at the middle region of the respective back main busbar 31. Similarly, by making the area of the respective fourth solder pad 2112 less than or equal to 2/3 of the area of the respective sixth solder pad 3112, the welding tension between the respective fourth solder pad 2112 and the corresponding solder strip can be kept to be close to the welding tension between the respective sixth solder pad 3112 and the corresponding solder strip. Since the area of the respective solder pad at the middle region of the respective electrode is relatively small, the area of the respective solder pad can be reduced only by reducing the size of the respective solder pad in one direction.

In some embodiments, the respective third solder pad 2111 and the respective fourth solder pad 2112 may both be a rectangular solder pad. The length (dimension L1 shown in FIG. 3) of the respective third solder pad 2111 is in a range of 0.5mm to 0.7mm in an extension direction of the respective front main busbar and the width (dimension W1 shown in FIG. 3) of the respective third solder pad 2111 is in a range of 0.9mm to 1.1mm in an extension direction of the respective front finger electrode. The length (dimension L2 shown in FIG. 3) of the respective fourth solder pad 2112 is in a range of 0.3mm to 0.5mm and the width (dimension W2 shown in FIG. 3) of the respective fourth solder pad 2112 is in a range of 0.7mm to 0.9mm.

In addition, the respective fifth solder pad 3111 and the respective sixth solder pad 3112 may both be a rectangular solder pad. The length (dimension L3 shown in FIG. 5) of the respective fifth solder pad 3111 is in a range of 0.7mm to 0.9mm in an extension direction of the respective back main busbar and the width (dimension W3 shown in FIG. 5) of the respective fifth solder pad 3111 is in a range of 1.1mm to 1.3mm in an extension direction of the respective back finger electrode. The length (dimension L4 shown in FIG. 5) of the respective sixth solder pad 3112 is in a range of 0.5mm to 0.7mm and the width (dimension W4 shown in FIG. 5) of the respective sixth solder pad 3112 is in a range of 0.7mm to 0.9mm.

In the present invention, the length of the respective first solder pad 211 in a first direction is less than or equal to 2/3 of the length of the corresponding second solder pad 311 in a first direction, where the first direction is parallel to an extension direction of the respective front main busbar 21.

That is, the size of the respective first solder pad 211 in the extension direction of the respective front main busbar 21 is reduced by more than 1/3 with respect to the size of the corresponding second solder pad 311 in the extension direction of the respective back main busbar 31. It is to be noted that the size of the respective solder pad in the extension direction of the respective main busbar contributes to the welding tension between the respective solder pad and the corresponding solder strip. Therefore, by mainly reducing the size of the respective first solder pad 211 in the extension direction of the respective main busbar, the solder tension between the respective first solder pad 211 and the corresponding solder strip can be significantly reduced.

In addition, the length of the respective first solder pad 211 in the first direction may be greater than a width of the respective front main busbar 21, and the length of the corresponding second solder pad 311 in the first direction may be greater than a width of the respective back main busbar 31.

By making the size of the respective solder pad in the extension direction of the respective main busbar larger than the width of the respective main busbar, the respective solder pad can be protruded from both sides of the respective main busbar in the extension direction of the respective main busbar, thus facilitating positioning of the solder strip during welding.

In some embodiments of the present disclosure, an adjacent spacing between the first solder pads 211 and an adjacent spacing between the second solder pads 311 each may be in a range of 15mm to 20mm.

The adjacent spacing between the solder pads refers to a spacing between two adjacent solder pads. By keeping the spacing between each two adjacent first solder pads 211 and the spacing between each two adjacent second solder pads 311 in the range of 15mm to 20mm, it is possible to avoid affecting the welding process due to too small adjacent spacing between the solder pads, and avoid affecting the connection effect between the solder strip and the solar cells due to too large adjacent spacing of the solder pads.

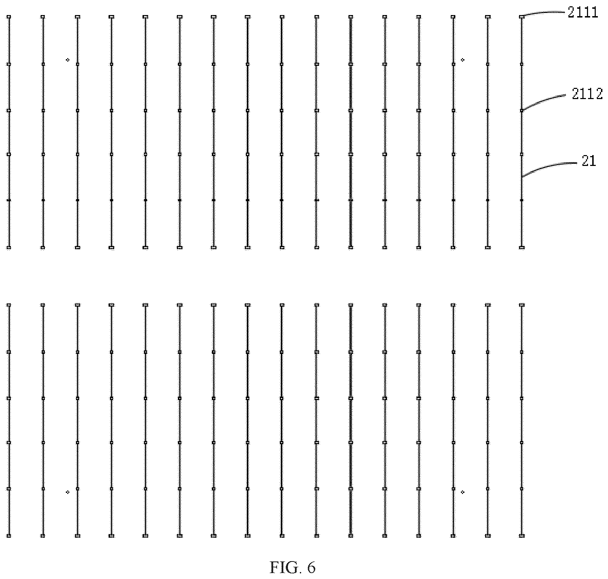

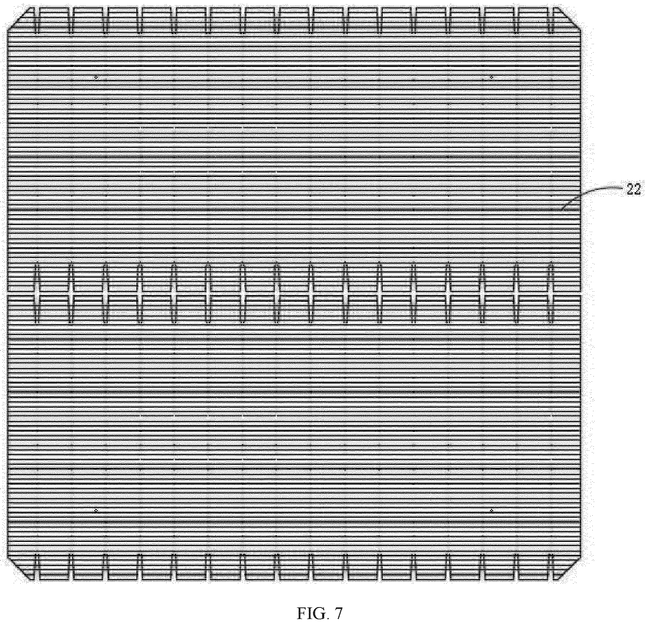

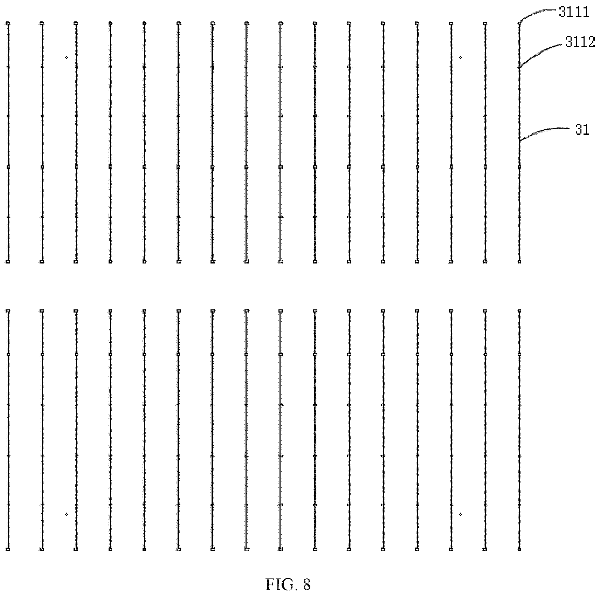

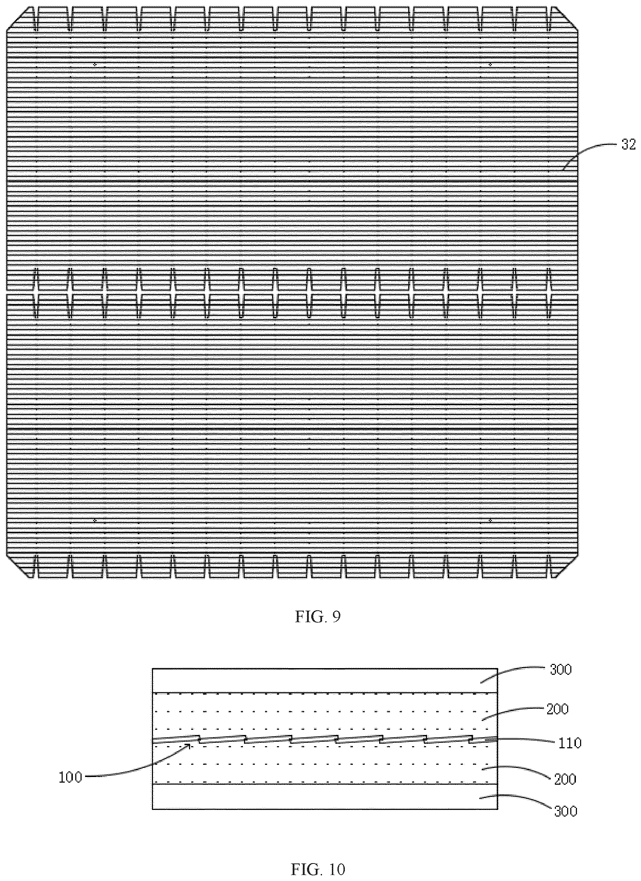

In addition, the solar cells provided in some embodiments of the disclosure may be constructed in the form of half-cut cells. The solar cell printed with electrodes is cut into two pieces of cells along in a symmetry axis of the respective front main busbar of the respective front electrode 20 and then the two pieces of cells are connected. During printing of the electrodes, a step-by-step printing process can be adopted. For example, during preparing the front electrodes 20, the front main busbars 21 (shown in FIG. 6) of the front electrodes 20 are printed first. The number of the front main busbars 21 may be 16. The number of first solder pads 211 on a single front main busbar 21 is 6 (including two rectangular third solder pads 2111 and four rectangular fourth solder pads 2112). The respective third solder pad 2111 at each end (near the bifurcation position) of the respective front main busbar 21 has a length of 0.6mm and a width of 1.0mm. The respective fourth solder pad 2112 at the middle region of the respective front main busbar 21 has a length of 0.4mm and a width of 0.8mm. Thereafter, the front finger electrodes 22 (shown in FIG. 7) of the front electrodes 20 are printed and the printed substrate 10 is sintered. The preparation of the back electrodes 30 is similar to the preparation of the front electrodes 20. The back main busbars 31(as shown in FIG. 8) of the back electrodes 30 are printed first. The number of the back main busbars 31 may be 16, and the number of second solder pads 311 on a single back main busbar 31 is 6 (including two rectangular fifth solder pads 3111 and four rectangular sixth solder pads 3112). The respective fifth solder pad 3111 at each end (near the bifurcation position) of the respective back main busbar 31 has a length of 0.8mm and a width of 1.2mm. The respective sixth solder pad at the middle region of the respective back main busbar 31 has a length of 0.6mm and a width of 0.8mm. Thereafter, the back finger electrodes 32 (shown in FIG. 9) of the back electrodes 30 are printed and the printed substrate 10 is sintered.

Table 1 below shows test results of welding tensions between the respective front solder pad on the substrate 10 of the solar cell and the corresponding solder strip and between the respective back solder pad on the substrate 10 and the corresponding solder strip after the area of each of the front solder pads is reduced according to some embodiments of the disclosure. The area of each of head and tail solder pads (i.e., each respective third solder pad 2111) of the respective front main busbar 21 located on the front side of the substrate 10 is 0.6 square millimeters. The area of each of middle solder pads (i.e., each respective fourth solder pad 2112) of the respective front main busbar 21 is 0.32 square millimeters. The area of each of head and tail solder pads (i.e., each respective fifth solder pad 3111) of the respective back main busbar 31 located on the back side of the substrate 10 is 0.96 square millimeters. The area of each of middle solder pads (i.e., each respective sixth solder pad 3112) of the respective back main busbar 31 is 0.48 square millimeters. The head and tail solder pads are the first and the sixth of the solder pads, and the middle solder pads are the second to the fifth of the solder pads. A single solar cell include 16 front main busbars 21 and 16 back main busbars 31, and three front main busbars 21 and three back main busbars 31 are selected to illustrate the tensile force test results. It is to be noted that the qualified tensile force value at each solder pad on both the front and back sides of the substrate 10 is 0.8N. A minimum allowable area of the respective solder pad is 0.10 square millimeters. A minimum allowable length of the respective solder pad is 0.2mm, and a minimum allowable width of the respective solder pad is 0.5mm.

Table 1 is a recording table of welding tension test results after the area of the respective front solder pad is reduced according to the embodiment of the disclosure.

**Table 1**

| N-th solder pad | 1 | 2 | 3 | 4 | 5 | 6 | Mean value of drawing forces corresponding to the single main busbar |
|---|---|---|---|---|---|---|---|
| Drawing force of the respective solder strip at different solder pads on a single front main busbar/N | 2.5 | 2.0 | 2.4 | 1.8 | 2.2 | 3.1 | 2.5 |
| | 4.9 | 1.9 | 3.0 | 2.6 | 1.6 | 3.3 | 2.7 |
| | 5.4 | 1.6 | 2.0 | 2.2 | 2.2 | 3.3 | 2.7 |
| Drawing force of the respective solder strip at different solder pads on a single back main busbar/N | 4.1 | 2.3 | 2.2 | 2.5 | 2.1 | 3.7 | 2.8 |
| | 3.0 | 1.8 | 2.1 | 2.6 | 2.7 | 2.8 | 2.5 |
| | 4.0 | 2.6 | 3.4 | 2.7 | 1.6 | 3.4 | 2.9 |

In addition, Table 2 below shows welding tension test results when an area of the respective front solder pad on the substrate and an area of the corresponding back solder pad on the substrate are the same according to some comparative examples. The area of each of the head and tail solder pads of the respective front main busbar located on the front side of the substrate and the area of a corresponding one of the head and tail solder pads of the respective back main busbar located on the back side of the substrate 10 are both 0.96 square millimeters. The area of the respective middle solder pad of the respective front main busbar and the area of the corresponding middle solder pad of the respective back main busbar are both 0.48 square millimeters. The head and tail solder pads are the first and the sixth of the solder pads, and the middle solder pads are the second to the fifth of the solder pads. The number of the front main busbars 21 and the number of the back main busbars 31 of a single solar cell are both 16, and three front main busbars 21 and three back main busbars 31 are selected to illustrate the tensile force test results.

Table 2 is a recording table of welding tension test results when the area of the respective front solder pad and the area of the corresponding back solder pad are the same according to comparative examples.

**Table 2**

| N-th solder pad | 1 | 2 | 3 | 4 | 5 | 6 | Mean value of drawing forces corresponding to the single main busbar |
|---|---|---|---|---|---|---|---|
| Drawing force of the respective solder strip at different solder pads on a single front main busbar/N | 5.6 | 2.1 | 2.8 | 1.6 | 3.6 | 4.9 | 3.4 |
| | 4.7 | 1.9 | 1.9 | 3.0 | 3.9 | 4.5 | 3.3 |
| | 4.8 | 2.1 | 3.6 | 3.2 | 3.8 | 4.1 | 3.6 |
| Drawing force of the respective solder strip at different solder pads on a single back main busbar/N | 3.2 | 1.6 | 1.7 | 1.0 | 1.0 | 3.8 | 2.0 |
| | 3.7 | 2.1 | 2.0 | 1.7 | 1.7 | 3.5 | 2.5 |
| | 3.8 | 1.2 | 2.2 | 1.6 | 1.2 | 2.6 | 2.1 |

By comparing the drawing force test results of the respective solder strip at different solder pads in Table 1 and Table 2, it is obvious that the drawing force of the respective solder strip at each respective solder pad on the respective front main busbar 21 is significantly larger than that at a corresponding solder pad on the respective back main busbar 31 when the area of the respective front solder pad on the substrate 10 and the area of the corresponding back solder pad on the substrate 10 are the same. In addition, in embodiments of the disclosure, the drawing force of the respective solder strip at the respective solder pad on the respective front main busbar 21 can be kept to be close to the drawing force of the respective solder strip at the corresponding solder pad on the respective back main busbar 31 after the area of the respective solder pad on the respective front main busbar 21 is reduced. Moreover, the area of the respective solder pad on the respective front main busbar 21 can be reduced by 1/3 or more relative to the area of the corresponding solder pad on the respective back main busbar 31.

Table 3 below gives test results of welding tensions between the respective front/back solder pad and the corresponding solder strip after the area of the respective front solder pad on the substrate 10 of the solar cell is reduced to a small range according to embodiments of the disclosure. The area of each of the head and tail solder pads (i.e., third solder pads 2111) and middle solder pads (i.e., fourth solder pads 2112) of the respective front main busbar 21 located on the front side of the substrate 10 is 0.15 square millimeters, and the area of each of the head and tail solder pads (i.e., fifth solder pads 3111) and middle solder pads (i.e., sixth solder pads 3112) of the respective back main busbar 31 located on the back side of the substrate 10 is 0.25 square millimeters. The head and tail solder pads are the first and the sixth of the solder pads, and the middle solder pads are the second to the fifth of the solder pads. The number of the front main busbars 21 and the back main busbars 31 of the single solar cell are both 16, and three front main busbars 21 and three back main busbars 31 are selected to illustrate the tensile force test results.

Table 3 is a recording table of welding tension test results after the area of the respective front solder pad is reduced according to embodiment of the disclosure.

**Table 3**

| N-th solder pad | 1 | 2 | 3 | 4 | 5 | 6 | Mean value of drawing forces corresponding to the single main busbar |
|---|---|---|---|---|---|---|---|
| Drawing force of the respective solder strip at different solder pads on a single front main busbar/N | 1.2 | 1.1 | 1.1 | 1.2 | 1.3 | 1.4 | 1.2 |
| | 1.2 | 1.8 | 1.4 | 1.4 | 1.3 | 1.4 | 1.4 |
| | 1.3 | 1.4 | 1.7 | 1.1 | 1.4 | 1.6 | 1.4 |
| Drawing force of the respective solder strip at different solder pads on a single back main busbar/N | 1.0 | 0.9 | 1.4 | 1.2 | 1.2 | 1.3 | 1.1 |
| | 1.0 | 0.9 | 1.1 | 1.3 | 1.2 | 1.1 | 1.1 |
| | 1.0 | 1.1 | 1.3 | 1.2 | 1.3 | 0.9 | 1.1 |

Tables 4 and 5 below show test results of the welding tensions between the respective solder pad and the corresponding solder strip when the area of the respective front solder pad and the area of the corresponding back solder pad of the substrate 10 of the cell are the same according to some comparative examples. Table 4 shows the drawing force test results obtained when the area of each of the front and back solder pads (including the first solder pads 211 on the respective front main busbar 21 and the second solder pads 311 on the respective back main busbar 31) of the substrate 10 is 0.25 square millimeters. A single solar cell include 16 front main busbars 21 and 16 back main busbars 31, and three front main busbars 21 and three back main busbars 31 are selected to illustrate the tensile force test results. Table 5 is a drawing force test results obtained when the area of each of the front and back solder pads (including the first solder pads 211 on the respective front main busbar 21 and the second solder pads 311 on the respective back main busbar 31) of the substrate 10 is 0.15 square millimeters. A single solar cell include 16 front main busbars 21 and 16 back main busbars 31, and three front main busbars 21 and three back main busbars 31 are selected to illustrate the tensile force test results.

Table 4 is a recording table of welding tension test results when the area of each of the front and back solder pads is 0.15 square millimeters according to the comparative examples.

**Table 4**

| N-th solder pad | 1 | 2 | 3 | 4 | 5 | 6 | Mean value of drawing forces corresponding to the single main busbar |
|---|---|---|---|---|---|---|---|
| Drawing force of the respective solder strip at different solder pads on a single front main busbar/N | 1.2 | 1.1 | 1.1 | 1.2 | 1.3 | 1.4 | 1.2 |
| | 1.2 | 1.8 | 1.4 | 1.4 | 1.3 | 1.4 | 1.4 |
| | 1.3 | 1.4 | 1.7 | 1.1 | 1.4 | 1.6 | 1.4 |
| Drawing force of the respective solder strip at different solder pads on a single back main busbar/N | 0.8 | 0.6 | 0.7 | 0.5 | 1.0 | 0.9 | 0.7 |
| | 0.7 | 1.2 | 0.6 | 0.6 | 0.8 | 0.9 | 0.8 |
| | 0.6 | 0.9 | 0.6 | 0.8 | 0.7 | 1.0 | 0.7 |

Table 5 is a recording table of welding tension test results when the area of each of the front and back solder pads is 0.25 square millimeters according to the comparative examples.

**Table 5**

| N-th solder pad | 1 | 2 | 3 | 4 | 5 | 6 | Mean value of drawing forces corresponding to the single main busbar |
|---|---|---|---|---|---|---|---|
| Drawing force of the respective solder strip at different solder pads on a single front main busbar/N | 1.4 | 1.6 | 1.3 | 2.0 | 1.5 | 1.4 | 1.5 |
| | 1.7 | 1.4 | 1.4 | 1.9 | 1.5 | 1.6 | 1.5 |
| | 1.3 | 1.5 | 1.7 | 1.6 | 1.5 | 1.8 | 1.5 |
| Drawing force of the respective solder strip at different solder pads on a single back main busbar/N | 1.0 | 0.9 | 1.4 | 1.2 | 1.2 | 1.3 | 1.1 |
| | 1.0 | 0.9 | 1.1 | 1.3 | 1.2 | 1.1 | 1.1 |
| | 1.0 | 1.1 | 1.3 | 1.2 | 1.3 | 0.9 | 1.1 |

According to the drawing force test results of the corresponding solder strip at different solder pads in Table 4, it is obvious that the drawing force test results of the corresponding solder strip at different solder pads on the respective front main busbar 21 can still meet the requirements when the area of each solder pad on the respective front main busbar 21 is small. However, when the area of each solder pad on the back main busbar 31 is small, the drawing force test results of the corresponding solder strip at some solder pads on the respective back main busbar 31 do not meet the requirements.

Table 5 gives the drawing force test results of the respective solder strip at different solder pads when the area of the respective front solder pad on the substrate 10 is the same as the area of the corresponding back solder pad on the substrate 10. By comparing the drawing force test results of the respective solder strip at different solder pads in Table 3, Table 4, and Table 5, it is obvious that the area of each of the front solder pads on the substrate 10 can be reduced by a certain proportion compared with the area of the respective back solder pad when the area of each of the back solder pads on the substrate 10 is unchanged, which means that in practical situations, the printing paste unit consumption can be reduced by reducing the area of the respective front solder pad on the substrate 10. Moreover, when the printing paste unit consumption is reduced, the welding tensions between different solder pads on the front and back sides of the substrate 10 and the corresponding solder strips still meet the requirements.

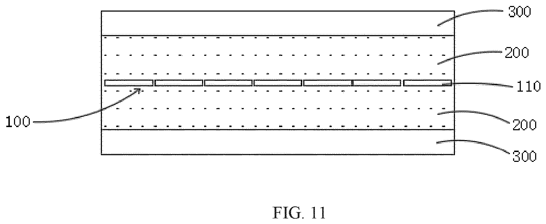

As shown in FIGS. 10 and 11, embodiments of the disclosure further provide a photovoltaic module. The photovoltaic module includes at least one cell string 100, a plurality of encapsulation films 200, and a plurality of cover plates 300. Each cell string 100 is formed by electrically connecting a plurality of solar cells 110, and each solar cell 110 is the solar cell described in the above embodiments. In other words, each solar cell 110 includes a substrate 10, a plurality of front electrodes 20 disposed on a front side of the substrate 10, and a plurality of back electrodes 30 disposed on a back side of the substrate 10. The plurality of front electrodes 20 include a plurality of front main busbars 21 and a plurality of front finger electrodes 22, and each of the plurality of front finger electrodes 22 is electrically connected with the plurality of front main busbars 21. There are 6 to 20 front main busbars 21 and 45 to 75 front finger electrodes 22. The plurality of back electrodes 30 include a plurality of back main busbars 31 and a plurality of back finger electrodes 32, and each of the plurality of back finger electrodes 32 is electrically connected with the plurality of back main busbars 31. There are 6 to 20 back main busbars 31 and 50 to 80 back finger electrodes 32. For each respective front main busbar 21 of at least one front main busbar 21 of the plurality of front main busbars 21, the respective front main busbar 21 has 4 to 10 first solder pads 211. For each respective back main busbar 31 of at least one back main busbar 31 of the plurality of back main busbars 31, the respective back main busbar 31 has 4 to 10 second solder pads 311. Each first solder pad 211 has an area smaller than an area of a corresponding second solder pad 311. Each encapsulation film 200 is used for covering a surface of each of the at least one cell string 100. Each cover plate 300 is used for covering a surface of a corresponding encapsulation film 200 facing away from the at least one cell string 100.

In FIG. 10, the solar cells 110 are arranged in a direction inclined with the plurality of cover plates 300, and in FIG. 11, the solar cells 110 are arranged in a direction parallel to the plurality of cover plates 300.

For each solar cell 110 of each of the at least one cell string 100 used in the photovoltaic module, an area of the respective first solder pad 211 in each respective front main busbar 21 of at least one front main busbar 21 of the solar cell 110 is smaller than an area of a corresponding second solder pad 311 in a respective back main busbar 31 of at least one back main busbar 31, so that the printing paste unit consumption of the solar cell can be reduced. Therefore, it is possible to avoid that the welding tension between the respective back solder pad and a corresponding solder strip is obviously less than that between the respective front solder pad and a corresponding solder strip when the area of the respective front solder pad is the same as the area of the respective back solder pad.

Those of ordinary skill in the art will appreciate that the above-described embodiments are specific embodiments for implementing the present disclosure and that in practical situations, various changes may be made in form and detail thereof without departing from the scope of the present disclosure.

## Claims

1. A solar cell, comprising:
a substrate (10) having a front side and a back side;
a plurality of front main busbars (21) and a plurality of front finger electrodes (22) on the front side of the substrate (10), wherein each respective front finger electrode (22) of the plurality of front finger electrodes (22) is electrically connected with the plurality of front main busbars (21), and there are 6 to 20 front main busbars (21);
a plurality of back main busbars (31) and a plurality of back finger electrodes (32) on the back side of the substrate (10), wherein each respective back finger electrode (32) of the plurality of back finger electrodes (32) is electrically connected with the plurality of back main busbars (31), and there are 6 to 20 back main busbars (31); and
the plurality of front main busbars (21) include branch busbar electrodes at ends of the plurality of front main busbars (21) and the plurality of back main busbars (31) include branch busbar electrodes at ends of the plurality of back main busbars (31);
wherein each respective front main busbar (21) of the plurality of front main busbars (21) includes 4 to 10 first solder pads (211) arranged at intervals in a first direction, wherein the first direction is parallel to an extension direction of the respective front main busbar (21);
wherein each respective back main busbar (31) of the plurality of back main busbars (31) includes 4 to 10 second solder pads (311) arranged at intervals in the first direction;
wherein each respective first solder pad (211) is disposed for a corresponding second solder pad (311);
**characterized in that**: the respective first solder pad (211) has an area smaller than an area of the corresponding second solder pad (311) by an amount such that a welding tension between the respective first solder pad (211) on the front side of the substrate (10) and a solder strip is the same as a welding tension between the corresponding second solder pad (311) on the back side of the substrate (10) and a solder strip; and
the respective first solder pad (211) has a length in the first direction that is less than or equal to 2/3 of a length of the corresponding second solder pad (311) in the first direction.

2. The solar cell of claim 1, wherein
the respective front main busbar (21) include two third solder pads (2111) located at the ends of the respective front main busbar (21) and a plurality of fourth solder pads (2112) located between the two third solder pads (2111), and wherein each respective third solder pad (2111) of the two third solder pads (2111) has an area larger than an area of a corresponding fourth solder pad (2112) of the plurality of fourth solder pads (2112); and
the respective back main busbar (31) include two fifth solder pads (3111) located at the ends of the respective back main busbar (31) and a plurality of sixth solder pads (3112) located between the two fifth solder pads (3111), and wherein each respective fifth solder pad (3111) of the two fifth solder pads (3111) has an area larger than an area of a corresponding sixth solder pad (3112) of the plurality of sixth solder pads (3112).

3. The solar cell of claim 1, wherein
the area of the respective third solder pad (2111) is less than or equal to 2/3 of the area of the respective fifth solder pad (3111); and/or
each respective fourth solder pad (2112) has an area less than or equal to 2/3 of an area of a respective sixth solder pad (3112).

4. The solar cell of claim 1, wherein the length of the respective first solder pad (211) in the first direction is greater than a width of the respective front main busbar (21), and the length of the corresponding second solder pad (311) in the first direction is greater than a width of the respective back main busbar (31).

5. The solar cell of claim 1, wherein a spacing between two adjacent first solder pads (211) and a spacing between two adjacent second solder pads (311) are both in a range of 15mm to 20mm.

6. The solar cell of claim 1, wherein the number of the plurality of front finger electrodes (22) is 35 to 100, and the number of the plurality of back finger electrodes (32) is 38 to 120.

7. The solar cell of claim 1, wherein any of the respective front finger electrode (22) and the respective back finger electrode (32) has a width in a range of 10µm to 80µm in an extension direction of the respective front main busbar (21);
wherein particularly, any of the respective front finger electrode (22) and the respective back finger electrode (32) has the width in a range of 20µm to 60µm.

8. The solar cell of any of claims 1 or 7, wherein any of the respective front finger electrode (22) and the respective back finger electrode (32) has a height in a range of 6µm to 18µm in a direction perpendicular to a surface of the substrate (10); and/or
wherein any of the plurality of front main busbars (21) has a height in a range of 3µm to 12µm, and any of the plurality of back main busbars (31) has a height in a range of 3µm to 12µm in a direction perpendicular to a surface of the substrate (10).

9. The solar cell of claim 1, wherein each of the plurality of front main busbars (21) has a width in a range of 15µm to 100µm, and each of the plurality of back main busbars (31) has a width in a range of 15µm to 100µm in an extension direction of the respective front finger electrode (22);
wherein particularly, each of the plurality of front main busbars (21) has the width in a range of 18µm to 80µm, and each of the plurality of back main busbars (31) has the width in a range of 18µm to 80µm.

10. A photovoltaic module, comprising:
at least one cell string, wherein each cell string is formed by connecting a plurality of solar cells, and each of the solar cells is the solar cell of any of claims 1 to 9;
a plurality of encapsulation films (200), wherein each encapsulation film (200) is used for covering a surface of each of the at least one cell string; and
a plurality of cover plates (300), wherein each cover plate (300) is used for covering a surface of a corresponding encapsulation film (200) away from the at least one cell string.

## Patentansprüche

1. Solarzelle, umfassend:
ein Substrat (10) mit einer Vorderseite und einer Rückseite;
eine Mehrzahl von vorderen Hauptsammelschienen (21) und eine Mehrzahl von vorderen Fingerelektroden (22) auf der Vorderseite des Substrats (10), wobei jede jeweilige vordere Fingerelektrode (22) der Mehrzahl von vorderen Fingerelektroden (22) elektrisch mit der Mehrzahl von vorderen Hauptsammelschienen (21) verbunden ist, und wobei 6 bis 20 vordere Hauptsammelschienen (21) vorhanden sind;
eine Mehrzahl von hinteren Hauptsammelschienen (31) und eine Mehrzahl von hinteren Fingerelektroden (32) auf der Rückseite des Substrats (10), wobei jede jeweilige hintere Fingerelektrode (32) der Mehrzahl von hinteren Fingerelektroden (32) elektrisch mit der Mehrzahl von hinteren Hauptsammelschienen (31) verbunden ist, und wobei 6 bis 20 hintere Hauptsammelschienen (31) vorhanden sind; und
die Mehrzahl von vorderen Hauptsammelschienen (21) verzweigte Sammelschienenelektroden an Enden der Mehrzahl von vorderen Hauptsammelschienen (21) umfasst, und die Mehrzahl von hinteren Hauptsammelschienen (31) verzweigte Sammelschienenelektroden an Enden der Mehrzahl von hinteren Hauptsammelschienen (31) umfasst;
wobei jede jeweilige vordere Hauptsammelschiene (21) der Mehrzahl von vorderen Hauptsammelschienen (21) 4 bis 10 erste Lötpads (211) umfasst, die in einer ersten Richtung in Abständen angeordnet sind, wobei die erste Richtung parallel zu einer Erstreckungsrichtung der jeweiligen vorderen Hauptsammelschiene (21) ist;
wobei jede jeweilige hintere Hauptsammelschiene (31) der Mehrzahl von hinteren Hauptsammelschienen (31) 4 bis 10 zweite Lötpads (311) umfasst, die in der ersten Richtung in Abständen angeordnet sind;
wobei jedes jeweilige erste Lötpad (211) für ein entsprechendes zweites Lötpad (311) vorgesehen ist;
**dadurch gekennzeichnet, dass**:
das jeweilige erste Lötpad (211) eine Fläche aufweist, die kleiner ist als eine Fläche des entsprechenden zweiten Lötpads (311), und zwar um einen solchen Betrag, dass eine Schweißspannung zwischen dem jeweiligen ersten Lötpad (211) auf der Vorderseite des Substrats (10) und einem Lötband gleich einer Schweißspannung zwischen dem entsprechenden zweiten Lötpad (311) auf der Rückseite des Substrats (10) und einem Lötband ist; und
das jeweilige erste Lötpad (211) in der ersten Richtung eine Länge aufweist, die kleiner oder gleich 2/3 einer Länge des entsprechenden zweiten Lötpads (311) in der ersten Richtung ist.

2. Solarzelle nach Anspruch 1, wobei
die jeweilige vordere Hauptsammelschiene (21) zwei dritte Lötpads (2111) umfasst, die an den Enden der jeweiligen vorderen Hauptsammelschiene (21) angeordnet sind, sowie eine Mehrzahl von vierten Lötpads (2112), die zwischen den zwei dritten Lötpads (2111) angeordnet sind, wobei jedes jeweilige dritte Lötpad (2111) der zwei dritten Lötpads (2111) eine Fläche aufweist, die größer ist als eine Fläche eines entsprechenden vierten Lötpads (2112) der Mehrzahl von vierten Lötpads (2112); und
die jeweilige hintere Hauptsammelschiene (31) zwei fünfte Lötpads (3111) umfasst, die an den Enden der jeweiligen hinteren Hauptsammelschiene (31) angeordnet sind, sowie eine Mehrzahl von sechsten Lötpads (3112), die zwischen den zwei fünften Lötpads (3111) angeordnet sind, wobei jedes jeweilige fünfte Lötpad (3111) der zwei fünften Lötpads (3111) eine Fläche aufweist, die größer ist als eine Fläche eines entsprechenden sechsten Lötpads (3112) der Mehrzahl von sechsten Lötpads (3112).

3. Solarzelle nach Anspruch 1, wobei
die Fläche des jeweiligen dritten Lötpads (2111) kleiner oder gleich 2/3 der Fläche des jeweiligen fünften Lötpads (3111) ist; und/oder
jedes jeweilige vierte Lötpad (2112) eine Fläche aufweist, die kleiner oder gleich 2/3 einer Fläche eines jeweiligen sechsten Lötpads (3112) ist.

4. Solarzelle nach Anspruch 1, wobei die Länge des jeweiligen ersten Lötpads (211) in der ersten Richtung größer ist als eine Breite der jeweiligen vorderen Hauptsammelschiene (21), und die Länge des entsprechenden zweiten Lötpads (311) in der ersten Richtung größer ist als eine Breite der jeweiligen hinteren Hauptsammelschiene (31).

5. Solarzelle nach Anspruch 1, wobei ein Abstand zwischen zwei benachbarten ersten Lötpads (211) und ein Abstand zwischen zwei benachbarten zweiten Lötpads (311) jeweils in einem Bereich von 15 mm bis 20 mm liegen.

6. Solarzelle nach Anspruch 1, wobei die Anzahl der Mehrzahl von vorderen Fingerelektroden (22) 35 bis 100 beträgt, und die Anzahl der Mehrzahl von hinteren Fingerelektroden (32) 38 bis 120 beträgt.

7. Solarzelle nach Anspruch 1, wobei eine beliebige der jeweiligen vorderen Fingerelektrode (22) und der jeweiligen hinteren Fingerelektrode (32) eine Breite in einem Bereich von 10 µm bis 80 µm in einer Erstreckungsrichtung der jeweiligen vorderen Hauptsammelschiene (21) aufweist;
wobei insbesondere eine beliebige der jeweiligen vorderen Fingerelektrode (22) und der jeweiligen hinteren Fingerelektrode (32) die Breite in einem Bereich von 20 µm bis 60 µm aufweist.

8. Solarzelle nach einem der Ansprüche 1 oder 7, wobei eine beliebige der jeweiligen vorderen Fingerelektrode (22) und der jeweiligen hinteren Fingerelektrode (32) eine Höhe in einem Bereich von 6 µm bis 18 µm in einer Richtung senkrecht zu einer Oberfläche des Substrats (10) aufweist; und/oder
wobei eine beliebige der Mehrzahl von vorderen Hauptsammelschienen (21) eine Höhe in einem Bereich von 3 µm bis 12 µm aufweist, und eine beliebige der Mehrzahl von hinteren Hauptsammelschienen (31) eine Höhe in einem Bereich von 3 µm bis 12 µm in einer Richtung senkrecht zu einer Oberfläche des Substrats (10) aufweist.

9. Solarzelle nach Anspruch 1, wobei jede der Mehrzahl von vorderen Hauptsammelschienen (21) eine Breite in einem Bereich von 15 µm bis 100 µm aufweist, und jede der Mehrzahl von hinteren Hauptsammelschienen (31) eine Breite in einem Bereich von 15 µm bis 100 µm in einer Erstreckungsrichtung der jeweiligen vorderen Fingerelektrode (22) aufweist;
wobei insbesondere jede der Mehrzahl von vorderen Hauptsammelschienen (21) die Breite in einem Bereich von 18 µm bis 80 µm aufweist, und jede der Mehrzahl von hinteren Hauptsammelschienen (31) die Breite in einem Bereich von 18 µm bis 80 µm aufweist.

10. Photovoltaikmodul, umfassend:
mindestens einen Zellenstrang, wobei jeder Zellenstrang durch Verbinden einer Mehrzahl von Solarzellen gebildet ist, und wobei jede der Solarzellen die Solarzelle nach einem der Ansprüche 1 bis 9 ist;
eine Mehrzahl von Verkapselungsfolien (200), wobei jede Verkapselungsfolie (200) zum Abdecken einer Oberfläche jedes des mindestens einen Zellenstrangs verwendet wird; und
eine Mehrzahl von Abdeckplatten (300), wobei jede Abdeckplatte (300) zum Abdecken einer von dem mindestens einen Zellenstrang abgewandten Oberfläche einer entsprechenden Verkapselungsfolie (200) verwendet wird.

## Revendications

1. Une cellule solaire, comprenant :
un substrat (10) ayant une face avant et une face arrière ;
une pluralité de barres collectrices principales avant (21) et une pluralité d'électrodes digitées avant (22) sur la face avant du substrat (10), dans laquelle chaque électrode digitée avant (22) respective de la pluralité d'électrodes digitées avant (22) est électriquement connectée à la pluralité de barres collectrices principales avant (21), et il y a de 6 à 20 barres collectrices principales avant (21) ;
une pluralité de barres collectrices principales arrière (31) et une pluralité d'électrodes digitées arrière (32) sur la face arrière du substrat (10), dans laquelle chaque électrode digitée arrière (32) respective de la pluralité d'électrodes digitées arrière (32) est électriquement connectée à la pluralité de barres collectrices principales arrière (31), et il y a de 6 à 20 barres collectrices principales arrière (31) ; et
la pluralité de barres collectrices principales avant (21) comprend des électrodes de barre collectrice ramifiées aux extrémités de la pluralité de barres collectrices principales avant (21), et la pluralité de barres collectrices principales arrière (31) comprend des électrodes de barre collectrice ramifiées aux extrémités de la pluralité de barres collectrices principales arrière (31) ;
dans laquelle chaque barre collectrice principale avant (21) respective de la pluralité de barres collectrices principales avant (21) comprend de 4 à 10 premiers plots de soudure (211) disposés à intervalles dans une première direction, la première direction étant parallèle à une direction d'extension de la barre collectrice principale avant (21) respective ;
dans laquelle chaque barre collectrice principale arrière (31) respective de la pluralité de barres collectrices principales arrière (31) comprend de 4 à 10 deuxièmes plots de soudure (311) disposés à intervalles dans la première direction ;
dans laquelle chaque premier plot de soudure (211) respectif est disposé pour un deuxième plot de soudure (311) correspondant ;
**caractérisée en ce que** :
le premier plot de soudure (211) respectif a une aire inférieure à une aire du deuxième plot de soudure (311) correspondant, d'une quantité telle qu'une tension de soudage entre le premier plot de soudure (211) respectif sur la face avant du substrat (10) et une bande de soudure est identique à une tension de soudage entre le deuxième plot de soudure (311) correspondant sur la face arrière du substrat (10) et une bande de soudure ; et
le premier plot de soudure (211) respectif a une longueur, dans la première direction, inférieure ou égale à 2/3 d'une longueur du deuxième plot de soudure (311) correspondant dans la première direction.

2. La cellule solaire de la revendication 1, dans laquelle
la barre collectrice principale avant (21) respective comprend deux troisièmes plots de soudure (2111) situés aux extrémités de la barre collectrice principale avant (21) respective, et une pluralité de quatrièmes plots de soudure (2112) situés entre les deux troisièmes plots de soudure (2111), et dans laquelle chaque troisième plot de soudure (2111) respectif parmi les deux troisièmes plots de soudure (2111) a une aire supérieure à une aire d'un quatrième plot de soudure (2112) correspondant parmi la pluralité de quatrièmes plots de soudure (2112) ; et
la barre collectrice principale arrière (31) respective comprend deux cinquièmes plots de soudure (3111) situés aux extrémités de la barre collectrice principale arrière (31) respective, et une pluralité de sixièmes plots de soudure (3112) situés entre les deux cinquièmes plots de soudure (3111), et dans laquelle chaque cinquième plot de soudure (3111) respectif parmi les deux cinquièmes plots de soudure (3111) a une aire supérieure à une aire d'un sixième plot de soudure (3112) correspondant parmi la pluralité de sixièmes plots de soudure (3112).

3. La cellule solaire de la revendication 1, dans laquelle
l'aire du troisième plot de soudure (2111) respectif est inférieure ou égale à 2/3 de l'aire du cinquième plot de soudure (3111) respectif ; et/ou
chaque quatrième plot de soudure (2112) respectif a une aire inférieure ou égale à 2/3 d'une aire d'un sixième plot de soudure (3112) respectif.

4. La cellule solaire de la revendication 1, dans laquelle la longueur du premier plot de soudure (211) respectif dans la première direction est supérieure à une largeur de la barre collectrice principale avant (21) respective, et la longueur du deuxième plot de soudure (311) correspondant dans la première direction est supérieure à une largeur de la barre collectrice principale arrière (31) respective.

5. La cellule solaire de la revendication 1, dans laquelle un espacement entre deux premiers plots de soudure (211) adjacents et un espacement entre deux deuxièmes plots de soudure (311) adjacents sont tous deux compris dans une plage de 15 mm à 20 mm.

6. La cellule solaire de la revendication 1, dans laquelle le nombre de la pluralité d'électrodes digitées avant (22) est de 35 à 100, et le nombre de la pluralité d'électrodes digitées arrière (32) est de 38 à 120.

7. La cellule solaire de la revendication 1, dans laquelle l'une quelconque de l'électrode digitée avant (22) respective et de l'électrode digitée arrière (32) respective a une largeur comprise dans une plage de 10 µm à 80 µm dans une direction d'extension de la barre collectrice principale avant (21) respective ;
dans laquelle, en particulier, l'une quelconque de l'électrode digitée avant (22) respective et de l'électrode digitée arrière (32) respective a la largeur comprise dans une plage de 20 µm à 60 µm.

8. La cellule solaire de l'une quelconque des revendications 1 ou 7, dans laquelle l'une quelconque de l'électrode digitée avant (22) respective et de l'électrode digitée arrière (32) respective a une hauteur comprise dans une plage de 6 µm à 18 µm dans une direction perpendiculaire à une surface du substrat (10) ; et/ou
dans laquelle l'une quelconque de la pluralité de barres collectrices principales avant (21) a une hauteur comprise dans une plage de 3 µm à 12 µm, et l'une quelconque de la pluralité de barres collectrices principales arrière (31) a une hauteur comprise dans une plage de 3 µm à 12 µm dans une direction perpendiculaire à une surface du substrat (10).

9. La cellule solaire de la revendication 1, dans laquelle chacune de la pluralité de barres collectrices principales avant (21) a une largeur comprise dans une plage de 15 µm à 100 µm, et chacune de la pluralité de barres collectrices principales arrière (31) a une largeur comprise dans une plage de 15 µm à 100 µm dans une direction d'extension de l'électrode digitée avant (22) respective ;
dans laquelle, en particulier, chacune de la pluralité de barres collectrices principales avant (21) a la largeur comprise dans une plage de 18 µm à 80 µm, et chacune de la pluralité de barres collectrices principales arrière (31) a la largeur comprise dans une plage de 18 µm à 80 µm.

10. Un module photovoltaïque, comprenant :
au moins une chaîne de cellules, chaque chaîne de cellules étant formée par la connexion d'une pluralité de cellules solaires, et chacune des cellules solaires étant la cellule solaire de l'une quelconque des revendications 1 à 9 ;
une pluralité de films d'encapsulation (200), chaque film d'encapsulation (200) étant utilisé pour recouvrir une surface de chacune de l'au moins une chaîne de cellules ; et
une pluralité de plaques de recouvrement (300), chaque plaque de recouvrement (300) étant utilisée pour recouvrir une surface, éloignée de l'au moins une chaîne de cellules, d'un film d'encapsulation (200) correspondant.
